# FASCICULE DE BREVET EUROPEEN

(11) **EP 0 756 719 B1**
(45) Date de publication et mention de la délivrance du brevet: **03.09.2003**
(21) Numéro de dépôt: 96904152.4
(22) Date de dépôt: 16.02.1996
(51) Int. Cl.: G02F 1/35, C30B 15/00

(54) **CRISTAUX NON LINEAIRES ET LEURS APPLICATIONS**
NICHTLINEARE KRISTALLE UND IHRE VERWENDUNGEN
NON-LINEAR CRYSTALS AND USES THEREOF

(30) Priorité: 21.02.1995 FR 9501963
(43) Date de publication de la demande: 05.02.1997
(73) Titulaire: Saint-Gobain Cristaux & Detecteurs, 77140 Saint-Pierre Les Nemours (FR)
(72) Inventeur: AKA, Gérard, F-93260 Les Lilas (FR); BLOCH, Laurence, F-38000 Grenoble (FR); GODARD, Jean, F-91120 Palaiseau (FR); KAHN-HARARI, Andrée, F-75013 Paris (FR); SALIN, François, F-91190 Villabe (FR); VIVIEN, Daniel, F-92380 Garches (FR)
(74) Mandataire: Le Cam, Stéphane Georges Elie
(86) Numéro de dépôt international: FR9600255
(87) Numéro de publication internationale: WO96026464

(56) Documents cités:
- US-A- 5 030 851
- US-A- 5 343 327
- US-A- 5 381 754
- LASER FOCUS WORLD, vol. 29, no. 9, Septembre 1993, TULSA US, pages 45-46, XP002003095 HOBBS: "Neodymium laser crystal diode pumped efficiently"

## Description

L'invention est relative à des cristaux pour l'optique non linéaire, à la fabrication de ces cristaux et aux applications de ces cristaux.

Les cristaux utilisés en optique non linéaire appartiennent à diverses familles qui présentent chacune des particularités bien spécifiques. Historiquement l'un des premiers produits apparus dans ce domaine est le dihydrogénophosphate de potassium (KDP). Ce matériau est encore très largement utilisé en raison de la relative facilité de fabrication et, en conséquence, de son coût relativement faible. En revanche, le KDP présente une grande sensibilité à l'eau ce qui implique quelques contraintes dans la façon de l'utiliser. Son coefficient de seconde harmonique est faible, ce qui conduit à une émission relativement faible du rayonnement de fréquence double. Si le KDP peut facilement former des monocristaux de bonnes dimensions, ce qui peut être nécessaire lorsqu'il faut pouvoir traiter des puissances relativement élevées, la plupart des cristaux pour l'optique non linéaire sont en pratique de petites dimensions. Ils sont en effet le plus souvent produits par croissance à partir de flux. C'est le cas de BBO, LBO et KTP. Dans ce mode, la croissance est très lente et requiert plusieurs semaines voire plusieurs mois pour parvenir à des dimensions convenables pour une majorité d'utilisations.

Il a été proposé des cristaux formés par fusion congruente selon les techniques de Czochralski ou Bridgman-Stockbarger. C'est le cas, par exemple, pour les cristaux de LiNbO₃. Les cristaux de LiNbO₃ présentent la particularité d'être photoréfractifs ce qui, pour la génération de seconde harmonique, est un inconvénient. Enfin les cristaux de LiNbO₃ sont très fragiles. Peut être également formé par fusion le LaBGeO₅. Cependant il est difficile à obtenir en raison de l'apparition de phases indésirables si la conduite de l'opération de cristallisation n'est pas parfaitement réglée. Par ailleurs, ce cristal n'offre qu'un coefficient de susceptibilité non linéaire relativement faible.

L'invention propose donc de produire des cristaux pour l'optique non linéaire à partir de leurs constituants fondus, leur fusion étant congruente. L'invention propose aussi l'utilisation de ces cristaux non linéaires notamment comme doubleurs ou mélangeurs de fréquence ou comme oscillateurs paramétriques optiques. L'invention propose encore l'utilisation de ces cristaux incorporant en quantité efficace un ion générateur d'effet laser en vue de la production de cristaux laser auto-doubleur de fréquence.

Selon l'invention, les matériaux mis en oeuvre répondent à la formule générale :

M₄LnO(BO₃)₃

dans laquelle :
- M est le Ca ou le Ca partiellement substitué par Sr ou Ba,
- Ln est un métal ou une combinaison de métaux du groupe comprenant Y, Gd, La, Lu et est éventuellement dopé au Nd.

Dans le cas d'une substitution partielle du Ca par Sr ou Ba, cette substitution est limitée à la teneur pour laquelle le bain fondu peut voir se développer des phases parasites lors de la cristallisation, autrement dit des valeurs pour lesquelles la phase M₄LnO(BO₃)₃ n'a a plus une fusion congruente.

Pour les composés du type :

Ca₄₋ₓSrₓLnO(BO₃)₃

- x est, de préférence, inférieur à 0,5 et mieux encore, inférieur à 0,30.

Pour les composés du type :

Ca_{4-y}Ba_{y}LnO(BO₃)₃

- y est, de préférence, inférieur à 0,5 et mieux encore, inférieur à 0,3.

Le choix du lanthanide peut avantageusement être orienté en fonction de l'utilisation projetée. En effet, les coefficients non linéaires et la biréfringence du matériau dépendent de la terre rare insérée dans la matrice.

Les cristaux selon l'invention peuvent, comme indiqué précédemment, être dopés au moyen d'ions lanthanides optiquement actifs, tel que le Nd³⁺. Les cristaux concernés sont de formule:

M₄Ln_{1-z}Nd_{z}O (BO₃)₃

dans laquelle :
- M et Ln ont les significations précédemment indiquées,
z dépend de l'effet recherché sachant que la présence d'éléments substituants peut conduire à une compétition dans les effets induits. L'augmentation de la concentration, dans un premier temps, a pour conséquence une augmentation de l'effet laser. Au-delà d'une certaine concentration en ions de substitution, on constate l'extinction progressive de l'émission. Les ions substitués deviennent trop « proches » les uns des autres et interagissent. Dans la pratique, la substitution ne dépasse pas 20 % et, de préférence, pas 10 %. Autrement dit z est, de préférence, inférieur à 0,2 et, de manière avantageuse, inférieur à 0,1. De manière générale, la concentration est telle que le temps de vie ne soit pas inférieur à la moitié du temps de vie maximum observable à faible concentration, soit 99 microsecondes.

Les cristaux non linéaires utilisés selon l'invention sont avantageusement obtenus par une méthode du type Czochralski ou Bridgman. Toute autre méthode de cristallogénèse à partir de la fusion peut convenir, en particulier la fusion de zone qui permet d'obtenir des fibres monocristallines de faible diamètre.

Les bains fondus sont obtenus à partir d'oxydes des lanthanides Ln₂O₃, des carbonates alcalino-terreux adéquats MCO₃ et d'acide ou d'anhydride borique. Les constituants en poudre sont intimement mélangés et portés à une température suffisante pour assurer la fusion du mélange. Cette température est maintenue le temps d'une homogénéisation complète. Le bain fondu est ensuite ramené à la température de cristallisation ce qui permet d'amorcer la formation d'un monocristal.

Pour la formation des cristaux dopés avec le Nd, la méthode est identique. Le mélange d'oxydes de lanthanides est simplement substitué au lanthanide unique.

L'invention est décrite de manière plus détaillée dans ce qui suit, notamment en se référant aux cristaux Ca₄GdO(BO₃)₃.

Le mélange initial est réalisé au moyen de 107 g de Gd₂O₃, 236 g de CaCO₃ et 109 g de H₃BO₃, constituant une charge d'oxydes d'environ 300 g. Le mélange effectué est placé dans un creuset en iridium d'environ 100 cm³ dans une atmosphère neutre ou dans un creuset de platine d'environ 100 cm³ sous oxygène. La température est portée à 1550°C pendant 2 heures. Elle est ensuite ramenée à proximité de la température de fusion congruente (1480°C). Un germe d'orientation cristallographique convenablement choisie est fixé sur une tige mobile en rotation selon son axe. Il est porté au contact de la surface du bain.

La rotation de la tige sur son axe est de 33 à 45 tours/min.

Après une période d'initiation de la cristallisation, la tige, toujours en rotation, est animée d'un mouvement de translation de l'ordre de 0,5 mm/h pendant les trois premières heures, puis de 2,5 mm/h.

La croissance régulière du monocristal est interrompue lorsque le cylindre formé atteint 8 cm pour un diamètre de 2 cm. Il est ramené à la température ambiante en 72 heures.

Le monocristal formé présente une très bonne homogénéité et ne comporte pas d'inclusion de bulles. Il est d'une dureté Mohs de 6,5.

Les autres cristaux selon l'invention sont préparés selon les mêmes techniques. Les fusions congruentes observées se situent dans la plage de température de 1400 à 1500°C.

Les cristaux obtenus sont résistants mécaniquement et chimiquement. Ils présentent la particularité d'être non hygroscopiques. De plus, ils se prêtent commodément aux opérations ultérieures de taille et polissage. Leur structure est monoclinique sans centre de symétrie, (groupe d'espace Cm).

Les caractéristiques cristallographiques de Ca₄GdO(BO₃)₃ sont :
- a = 8,092 Å
- b = 16,007 Å
- c = 3,561 Å
- β = 101,2°
- Z = 4
- densité d = 3,75

Les orientations des axes cristallophysiques X, Y, Z par rapport aux axes cristallographiques a, b, c sont :
- (Z, a) = 26°
- (Y, b) = 0°
- (X, c) = 15°

L'angle (V, z) entre l'axe optique et l'axe Z est tel que 2 (V, z) = 120,66°, ce qui définit le cristal comme bi-axe négatif.

Le cristal au gadolinium est transparent dans la plage 0,35-3 micromètres. Pour le composé à l'yttrium, la fenêtre de transparence est de 0,22-3 micromètres.

Les indices de réfraction en fonction de la longueur d'onde sont déterminés par la méthode du minimum de déviation. Ils s'établissent de la façon donnée au tableau suivant pour le cristal Ca₄GdO(BO₃)₃:

| λ (µm) | nₓ | n_{y} | n_{z} |
|---|---|---|---|
| 0.4047 | 1.7209 | 1.7476 | 1.7563 |
| 0.4358 | 1.7142 | 1.7409 | 1.7493 |
| 0.4678 | 1.7089 | 1.7350 | 1.7436 |
| 0.4800 | 1.7068 | 1.7333 | 1.7418 |
| 0.5090 | 1.7033 | 1.7295 | 1.7379 |
| 0.5461 | 1.6992 | 1.7253 | 1.7340 |
| 0.5780 | 1.6966 | 1.7225 | 1.7310 |
| 0.5876 | 1.6960 | 1.7218 | 1.7303 |
| 0.6439 | 1.6923 | 1.7181 | 1.7265 |
| 0.6678 | 1.6910 | 1.7168 | 1.7250 |
| 0.7290 | 1.6879 | 1.7133 | 1.7216 |
| 0.7960 | 1.6860 | 1.7112 | 1.7197 |

Partant des valeurs expérimentales ci-dessus, les formules de Sellmeier ont été établies :
- n²_{z} = 2,9222 + 0,02471 / (λ² - 0,01279) - 0,00820 λ²
- n²_{y} = 2,8957 + 0,02402 / (λ² - 0,01395) - 0,01039 λ²
- n²ₓ *=* 2,8065 + 0,02347 / (λ² - 0,01300) - 0,00356 λ²

A titre d'exemple, l'accord de phases pour le doublage de fréquence peut être obtenu pour des longueurs d'onde incidentes comprises entre 0,87 µm et 3 µm. Il est seulement de type I (les deux photons à la fréquence fondamentale ont la même polarisation) pour la longueur d'onde 1,064 µm d'un laser YAG dopé Nd ; il est de type I ou de type Il (les deux photons à la fréquence fondamentale ont des polarisations orthogonales) pour les longueurs d'onde comprises entre 1,064 et 3 µm.

Pour le borate étudié, les angles d'accord de phase de type I à 1,064 µm sont :

| | θ | ⌀ |
|---|---|---|
| plan (x,y) | 90° | 46,3° |
| (x,z) | 19,3° | 0° |

Les coefficients non-linéaires ont été déterminés par la méthode dite de « l'angle d'accord de phase », par comparaison avec un cristal étalon dans les plans principaux. Le plan ZX a donné les meilleures performances. C'est ainsi que :
d₁₂ = 0.56 pm/V
d₃₂ = 0.44 pm/V

La valeur du coefficient non linéaire effectif d_{eff}, mesurée dans le plan ZX, dans la plage de longueur d'onde fondamentale 788-1456 nm, représente 40 à 70% de celle du d_{eff} du BBO.

Exposé au flux lumineux d'un laser YAG à 1,064 µm (6ns), le cristal Ca₄GdO(BO₃)₃ présente un seuil de dommage voisin de 1 GW/cm², comparable à celui du BBO, dans les mêmes conditions.

L'acceptance angulaire du Ca₄GdO(BO₃)₃ est 2.15 mrd.cm, beaucoup plus élevée que celle du BBO (1.4 mrd).

L'angle de walk-off de Ca₄GdO(BO₃)₃ est de 0.7° (soit 13 mrd), soit 5 fois plus faible que celui de BBO (4° soit 70 mrd).

Le taux de conversion de la première à la deuxième harmonique atteint la valeur de 55%. Les cristaux produisent une réponse stable.

Au vu des caractéristiques du Ca₄GdO(BO₃)₃ décrites ci-dessus, les cristaux de Ca₄GdO(BO₃)₃ représentent un nouveau matériau doté d'excellentes propriétés non linéaires.

D'après le coefficient non linéaire effectif (d_{eff}) estimé, qui vaut entre 0.4 et 0.7 fois celui du BBO, l'efficacité du processus non-linéaire dans Ca₄GdO(BO₃)₃ devrait être exceptionnelle, dans la mesure où il est possible d'en élaborer des monocristaux de grande taille par la méthode Czochralski.

L'obtention de monocristaux de manière relativement rapide et de coût modéré, jointe aux caractéristiques énoncées précédemment, permettent leur utilisation commode dans diverses applications. Parmi ces applications, les plus usuelles concernent le doublement de fréquence de rayons lasers, notamment de ceux émettant dans l'infrarouge, donnant naissance à un rayonnement dans le visible.

Ces cristaux peuvent également servir à obtenir la somme ou la différence de fréquences entre deux faisceaux laser et à constituer des oscillateurs paramétriques optiques.

Toujours à titre d'exemple d'application, les cristaux étudiés précédemment ont fait l'objet d'un dopage au Nd. En particulier, les inventeurs ont étudié les propriétés d'un monocristal de Ca₄GdO(BO₃)₃ dopé au Nd. Les cristaux préparés comme précédemment étaient substitués pour 5 % du Gd par Nd.

Le cristal dopé offre l'avantage d'une très faible absorption pour des longueurs d'onde correspondant à la seconde harmonique, contrairement à ce que l'on observe par exemple pour les cristaux développés jusqu'à présent pour former des lasers doubleurs tels que les cristaux YAl₃(BO₃)₄ dopés au Nd (NYAB) qui présentent une absorption significative à 531 nm.

Le spectre d'absorption présente une bande large centrée à 810 nm dont la section efficace est mesurée à 1,5 x 10⁻²⁰cm².

L'émission du cristal dopé pour la transition ⁴F_{3/2} → ⁴I_{11/2} est à la longueur d'onde de 1060 nm avec une section efficace d'émission de 1,7 x 10⁻²⁰ cm².

Pour le taux de dopage de 5 % Nd, le temps de vie de l'état excité est 95 microsecondes.

Les tests laser effectués sur un cristal de Ca₄GdO(BO₃)₃, dopé avec du néodyme et taillé suivant les axes cristallophysiques X, Y et Z, ont conduit à l'observation de l'effet laser à 1060 nm, avec les caractéristiques suivantes :

| **Direction de propagation du faisceau de pompe** | **Puissance de seuil (mw)** | **Rendement différentiel (%)** | **Polarisation du faisceau laser émis** |
|---|---|---|---|
| X | 288 | 29 | E//Z |
| Y | 125 | 34 | E//X |
| Z | 210 | 29 | E//X |

Le doublage de fréquence produit un rayonnement à 530 nm donc hors des zones d'absorption intense du cristal. Pour cette raison, les lasers auto-doubleurs de fréquence selon l'invention permettent d'obtenir une forte intensité de cette seconde harmonique.

Les exemples indiqués précédemment n'ont pas de caractère limitatif. Ils sont donnés à titre d'illustration de l'invention dans certains de ses modes de réalisation. Ceux-ci montrent suffisamment les avantages procurés par l'invention de cristaux relativement peu coûteux, de grandes dimensions et offrant des propriétés intéressantes comme doubleurs ou mélangeurs de fréquence, oscillateurs paramétriques optiques ou encore comme lasers auto-doubleurs.

## Revendications

1. Monocristal non linéaire obtenu par cristallisation d'une composition fondue congruente et de formule générale :
M₄LnO(BO₃)₃
dans laquelle :
• M est le Ca ou le Ca partiellement substitué par Sr ou Ba,
• Ln est un métal ou une combinaison de métaux du groupe constitué de Y, Gd, La, Lu et est éventuellement dopé au Nd.

2. Monocristal non linéaire selon la revendication 1 obtenu par cristallisation d'une composition fondue congruente et de formule générale :
M₄LnO(BO₃)₃
dans laquelle :
• M est le Ca ou le Ca partiellement substitué par Sr ou Ba,
• Ln est l'un des lanthanides du groupe comprenant Y, Gd, La, Lu.

3. Monocristal selon l'une des revendications 1 ou 2 dans la formule générale duquel, lorsque Ca est partiellement substitué par Sr ou Ba, la teneur de l'élément substitué est limitée à celle pour laquelle la fusion n'est plus congruente.

4. Monocristal selon l'une des revendications 1 ou 2 de formule générale :
Ca₄₋ₓSrₓLnO(BO₃)₃
dans laquelle x est inférieur à 0,5.

5. Monocristal selon l'une des revendications 1 ou 2 de formule générale :
Ca_{4-y}Ba_{y}LnO(BO₃)₃
dans laquelle y est inférieur à 0,5.

6. Monocristal selon la revendication 1, ledit cristal étant dopé et répondant à la formule générale :
M₄Ln_{1-z}Nd_{z}O(BO₃)₃
dans laquelle :
• M et Ln ont les significations précédemment indiquées, Ln n'étant pas Nd,
• z est au plus égal à 0,2.

7. Application à l'optique non linéaire d'un monocristal de formule générale :
M₄Ln_{1-z}Nd_{z}O(BO₃)₃
dans laquelle M et Ln ont l'une des significations définies aux revendications 1 à 6, Ln n'étant pes Nd,

8. Application d'un monocristal à la constitution d'un laser auto-doubleur de fréquence selon la revendication 7 dans lequel M est Ca, Ln est Gd ou La et le dopant est Nd.

9. Application d'un monocristal selon l'une des revendication 1 à 6, ledit cristal étant utilisé comme doubleur de fréquence d'un laser distinct

10. Application d'un monocristal selon l'une des revendications 1 à 6 comme oscillateur paramétrique optique.

11. Application d'un monocristal selon l'une des revendications 1 à 6 comme mélangeur de fréquence de deux lasers distincts.

## Patentansprüche

1. Nichtlinearer Einkristall, der durch Kristallisation einer kongruenten geschmolzenen Zusammensetzung erhalten ist und die allgemeine Formel
M₄LnO(BO₃)₃
besitzt, in welcher
• M Ca oder teilweise durch Sr oder Ba substituiertes Ca und
• Ln ein Metall oder eine aus Metallen der von Y, Gd, La und Lu gebildeten Gruppe bestehende Kombination, das/die gegebenenfalls mit Nd dotiert ist,
bedeutet.

2. Nichtlinearer Einkristall nach Anspruch 1, der durch Kristallisation einer kongruenten geschmolzenen Zusammensetzung erhalten ist und die allgemeine Formel
M₄LnO(BO₃)₃
besitzt, in welcher
• M Ca oder teilweise durch Sr oder Ba substituiertes Ca und
• Ln eines der Lanthanide der Y, Gd, La und Lu umfassenden Gruppe bedeutet.

3. Einkristall nach Anspruch 1 oder 2, in dessen allgemeiner Formel, wenn Ca teilweise durch Sr oder Ba substituiert ist, der Gehalt des substituierten Elements auf denjenigen begrenzt ist, bei welchem die Schmelze nicht mehr kongruent ist.

4. Einkristall nach Anspruch 1 oder 2 mit der allgemeinen Formel
Ca₄₋ₓSrₓLnO(BO₃)₃,
in welcher x kleiner als 0,5 ist.

5. '. Einkristall nach Anspruch 1 oder 2 mit der allgemeinen Formel
Ca_{4-y}Ba_{y}LnO(BO₃)₃,
in welcher y kleiner als 0,5 ist.

6. Einkristall nach Anspruch 1, wobei der Kristall dotiert ist und der allgemeinen Formel
M₄Ln_{1-z}Nd_{z}O(BO₃)₃
entspricht, in welcher
• M und Ln die weiter oben angegebenen Bedeutungen haben, aber Ln nicht Nd sein darf, und
• z höchstens 0,2 ist.

7. Verwendung eines Einkristalls mit der allgemeinen Formel
M₄Ln_{1-z}Nd_{z}O(BO₃)₃,
in welcher M und Ln eine der in den Ansprüchen 1 bis 6 angegebenen Bedeutungen haben, aber Ln nicht Nd sein darf,
in der nichtlinearen Optik.

8. Verwendung eines Einkristalls, in welchem M Ca und Ln Gd oder La bedeutet und das Dotiermittel Nd ist, für den Bau eines automatischen Frequenzdopplungslasers nach Anspruch 7.

9. Verwendung eines Einkristalls nach einem der Ansprüche 1 bis 6, wobei der Kristall als Frequenzdoppler für einen bestimmten Laser verwendet wird.

10. Verwendung eines Einkristalls nach einem der Ansprüche 1 bis 6 als optischer parametrischer Oszillator.

11. Verwendung eines Einkristalls nach einem der Ansprüche 1 bis 6 als Frequenzmischer für zwei bestimmte Laser.

## Claims

1. Non-linear single crystal obtained by crystallization of a congruent molten composition of general formula:
M₄LnO(BO₃)₃
in which:
• M is Ca, or Ca partially substituted with Sr or Ba;
• Ln is a metal or a combination of metals in the group consisting of Y, Gd, La and Lu and is possibly doped with Nd.

2. Non-linear single crystal according to Claim 1 obtained by crystallization of a congruent molten composition of general formula:
M₄LnO(BO₃)₃
in which:
• M is Ca, or Ca partially substituted with Sr or Ba;
• Ln is one of the lanthanides of the group comprising Y, Gd, La and Lu.

3. Single crystal according to one of Claims 1 or 2, in the general formula of which, when Ca is partially substituted with Sr or Ba, the content of the substituted element is limited to that for which the melting is no longer congruent.

4. Single crystal according to one of Claims 1 or 2, of general formula:
Ca₄₋ₓSrₓLnO(BO₃)₃
in which x is less than 0.5.

5. Single crystal according to one of Claims 1 or 2, of general formula:
Ca_{4-y}Ba_{y}LnO(BO₃)₃
in which y is less than 0.5.

6. Single crystal according to Claim 1, the said crystal being doped and satisfying the general formula:
M₄Ln_{1-z}Nd_{z}O(BO₃)₃
in which:
• M and Ln have the meanings indicated above, Ln not being Nd,
• z is at most equal to 0.2.

7. Application to non-linear optics of a single crystal of general formula:
M₄Ln_{1-z}Nd_{z}O(BO₃)₃
in which M and Ln have one of the meanings defined in Claims 1 to 6, Ln not being Nd.

8. Application of a single crystal to the formation of a self-frequency-doubling laser according to Claim 7, in which M is Ca, Ln is Gd or La, and the dopant is Nd.

9. Application of a single crystal according to one of Claims 1 to 6, the said crystal being used as a frequency doubler for a separate laser.

10. Application of a single crystal according to one of Claims 1 to 6 as an optical parametric oscillator.

11. Application of a single crystal according to one of Claims 1 to 6 as a frequency mixer for two separate lasers.
